# EUROPEAN PATENT APPLICATION

(11) **EP 3 611 290 A1**
(43) Date of publication of application: **19.02.2020**
(21) Application number: 18783637.4
(22) Date of filing: 06.04.2018
(51) Int. Cl.: C23C 16/455

(54) **FILM FORMATION DEVICE AND FILM FORMATION METHOD**

(30) Priority: 10.04.2017 CN 201710229298
(71) Applicant: Shincron Co., Ltd., Kanagawa 220-8680 (JP)
(72) Inventor: NAGAE, Ekishu, Yokohama-shi Kanagawa 220-8680 (JP); MIYAUCHI, Mitsuhiro, Yokohama-shi Kanagawa 220-8680 (JP); OTAKI, Yoshiyuki, Yokohama-shi Kanagawa 220-8680 (JP); SHIGETA,Yuki, Yokohama-shi Kanagawa 220-8680 (JP); SAMORI, Shingo, Yokohama-shi Kanagawa 220-8680 (JP)
(74) Representative: Ter Meer Steinmeister & Partner
(86) International application number: PCT/JP2018/014736
(87) International publication number: WO 2018/190269

(57) **Abstract**

The present invention discloses a film formation device and a film formation method for film formation of thin films. The film formation device includes a vacuum chamber, an evacuation mechanism that is connected to the vacuum chamber and evacuates the vacuum chamber, a substrate holding mechanism that holds a substrate in the vacuum chamber, a film formation mechanism that is disposed in the vacuum chamber, and an introduction mechanism that is connected to the vacuum chamber and capable of introducing a hydroxyl group-containing gas into the vacuum chamber during film formation by the film formation mechanism.

## Description

### [Technical Field]

The present invention relates to a film formation device and a film formation method that are suitable for various types of films such as optical films and functional films.

The present application claims priority based on Chinese Patent Application No. 201710229298.7 filed on April 10, 2017. For those designated countries which permit the incorporation by reference, the content described and/or illustrated in the above application is incorporated by reference in the present application as part of the description and/or drawings of the present application.

### [Background Art]

In the field of optical films (including antireflective films) used for optical materials such as optical lenses and optical filters, if the optical properties of the optical films deteriorate to a certain extent, the properties of final products will significantly deteriorate. In this regard, improvement of the optical properties of optical films (such as light transmittance, for example) is desired.

A technique of forming anti-dirt films as an example of the type of functional films is known (Patent Document 1: JP2010-90454A). This method includes the following steps. First, two or more substrates to be processed are held on the entire surface of a substrate holding surface of a substrate holder, and the substrate holder is then rotated in a vacuum chamber. Subsequently, in a state of maintaining the rotation, all of the two or more substrates are continuously irradiated with ions (irradiation of entire surface with ions). Then, a film formation material composed of a raw material for forming the anti-dirt films is vaporized and deposited on all the substrates which are formed with surface irregularities by the ion irradiation (supply of film formation material to entire surface).

Through the above steps, anti-dirt films can be deposited on all the surfaces of the two or more substrates formed with irregularities. By employing the method, anti-dirt films having wear resistance that can withstand practical use can be formed (see paragraph 0029 of Patent Document 1). In recent years, however, it is desired to further improve the wear resistance of anti-dirt films.

### [Prior Art Document]

### [Patent Document]

[Patent Document 1] JP2010-90454A

### [Summary of Invention]

### [Problems to be solved by Invention]

Objects of the present invention include providing a film formation device and a film formation method for functional films having enhanced wear resistance and various properties such as water repellency, oil repellency, and anti-dirt properties.

### [Means for solving problems]

(1) The film formation device according to an aspect of the present invention comprises a vacuum chamber, an evacuation mechanism that is connected to the vacuum chamber and evacuates the vacuum chamber, a substrate holding mechanism that holds a substrate in the vacuum chamber, a film formation mechanism that is disposed in the vacuum chamber, and an introduction mechanism that is connected to the vacuum chamber and capable of introducing a hydroxyl group-containing gas into the vacuum chamber during film formation by the film formation mechanism.
(2) The film formation device according to another aspect of the present invention comprises a vacuum chamber, an evacuation mechanism that is connected to the vacuum chamber and evacuates the vacuum chamber, a substrate holding mechanism for holding a substrate in the vacuum chamber, a film formation mechanism that is disposed in the vacuum chamber, and an introduction mechanism that is connected to the vacuum chamber and capable of introducing a hydroxyl group-containing gas into the vacuum chamber after film formation by the film formation mechanism.
(3) The film formation device according to still another aspect of the present invention comprises a vacuum chamber, an evacuation mechanism that is connected to the vacuum chamber and evacuates the vacuum chamber, a substrate holding mechanism for holding a substrate in the vacuum chamber, a film formation mechanism that is disposed in the vacuum chamber, an introduction mechanism that is connected to the vacuum chamber and capable of introducing a hydroxyl group-containing gas to the substrate, and a moving mechanism that moves the substrate holding mechanism in the vacuum chamber thereby to allow the substrate to be intermittently supplied with the hydroxyl group-containing gas twice or more.
(4) In the film formation device according to the present invention, the hydroxyl group-containing gas may contain at least one of water and alcohol in a gaseous state.
(5) In the film formation device according to the present invention, the introduction mechanism may be able to introduce two or more types of hydroxyl group-containing gases.
(6) In the film formation device according to the present invention, the introduction mechanism may include a vaporizer that can vaporize water, and the vacuum chamber may be connected to the vaporizer via a pipe provided with a vacuum valve.
(7) In the film formation device according to the present invention, the pipe may be provided with a gas flow meter.
(8) In the film formation device according to the present invention, the gas flow meter may be disposed between the vacuum valve and the vaporizer.
(9) In the film formation device according to the present invention, one end of the pipe may be arranged to pass through a lower part of the vacuum chamber.
(10) In the film formation device according to the present invention, the thin film may include an anti-dirt film or a hard film.
(11) The film formation method according to an aspect of the present invention comprises a gas supply step of introducing a hydroxyl group-containing gas into a vacuum chamber and a film formation step of forming a thin film on a substrate, wherein the gas supply step and the film formation step are concurrently performed.
(12) The film formation method according to another aspect of the present invention comprises a gas supply step of introducing a hydroxyl group-containing gas into a vacuum chamber and a film formation step of forming a thin film on a substrate, wherein the gas supply step is performed after the film formation step.
(13) The film formation method according to still another aspect of the present invention may comprise a gas supply step of moving a substrate thereby to allow the substrate to be intermittently supplied with a hydroxyl group-containing gas and a film formation step of forming a thin film on the substrate.
(14) The film formation method according to the present invention may further comprise a preliminary gas supply step of introducing the hydroxyl group-containing gas into the vacuum chamber prior to the film formation step.
(15) In the film formation method according to the present invention, the hydroxyl group-containing gas may contain at least one of water vapor and alcohol vapor.
(16) In the film formation method according to the present invention, two or more types of hydroxyl group-containing gases may be introduced.
(17) In the film formation method according to the present invention, the gas supply step may include introducing the hydroxyl group-containing gas into the vacuum chamber to a first set pressure P1 and the first set pressure P1 may satisfy 1×10⁻³ Pa≤P1<1×10⁵ Pa.
(18) In the film formation method according to the present invention, the preliminary gas supply step may include introducing the hydroxyl group-containing gas into the vacuum chamber to a second set pressure P2 and the second set pressure P2 may satisfy 1×10⁻³ Pa≤P2<2×10⁴ Pa.
(19) In the film formation method according to the present invention, the film formation step may be performed immediately after the preliminary gas supply step.
(20) In the film formation method according to the present invention, the gas supply step may include introducing the hydroxyl group-containing gas for a time (t) and the time (t) may satisfy t≤60 min.
(21) In the film formation method according to the present invention, the preliminary gas supply step may include introducing the hydroxyl group-containing gas for a time (t) and the time (t) may satisfy t≤60 min.
(22) In the film formation method according to the present invention, the hydroxyl group-containing gas may be introduced at a rate of 1 to 10,000 sccm.
(23) The film formation method according to the present invention may comprise a silicon dioxide film formation step of performing film formation of silicon dioxide on the substrate prior to the preliminary gas supply step.
(24) In the film formation method according to the present invention, the hydroxyl group-containing gas may contain water vapor.
(25) In the film formation method according to the present invention, a material of the substrate may comprise at least one of glass, sapphire, aluminum, stainless steel, aluminum oxide, PET, polycarbonate (PC), and a triacetyl cellulose film (TAC).
(26) In the film formation method according to the present invention, the thin film may include an anti-dirt film or a hard film.

### [Effect of Invention]

According to the present invention, it is possible to form functional films having enhanced wear resistance and various properties such as water repellency, oil repellency, and anti-dirt properties.

### [Brief Description of Drawings]

FIG. 1 is a schematic diagram of a film formation device provided according to an embodiment of the present invention.
FIG. 2 is a schematic diagram of a substrate having a thin film formed by the device illustrated in FIG. 1.
FIG. 3 is a schematic diagram of film formation in a conventional technique without a step of introducing a hydroxyl group-containing gas.
FIG. 4 is a schematic diagram of film formation in the present embodiment with a step of introducing a hydroxyl group-containing gas.

### [Mode(s) for Carrying out the Invention]

In order for a person skilled in the art to better understand the technical content in the present invention, one or more embodiments of the present invention will be described hereinafter with reference to the drawings. It is apparent that the described embodiments are not all forms of the present invention but are merely some forms.

It is to be noted that when an element is referred to as being "provided" on or in another element, the element may be directly located on the other element or may also be present in the middle of the other element. When an element is considered to be "connected" to another element, the element may be directly connected to the other element or may also be coincidentally present in the middle of the other element. The terms "vertical," "horizontal," "left," "right," and similar terms as used herein are merely for descriptive purposes and are not intended to state that the relevant embodiment is one and only embodiment.

Unless otherwise defined, all the technical and scientific terms as used herein have the same meanings as commonly understood by a person skilled in the art. As used herein, the terms used in the description of the present application are merely for the purpose of describing specific embodiments and are not intended to limit the present invention. The term "and/or" as used herein includes a listed relevant item or any and all of combinations of two or more listed relevant items.

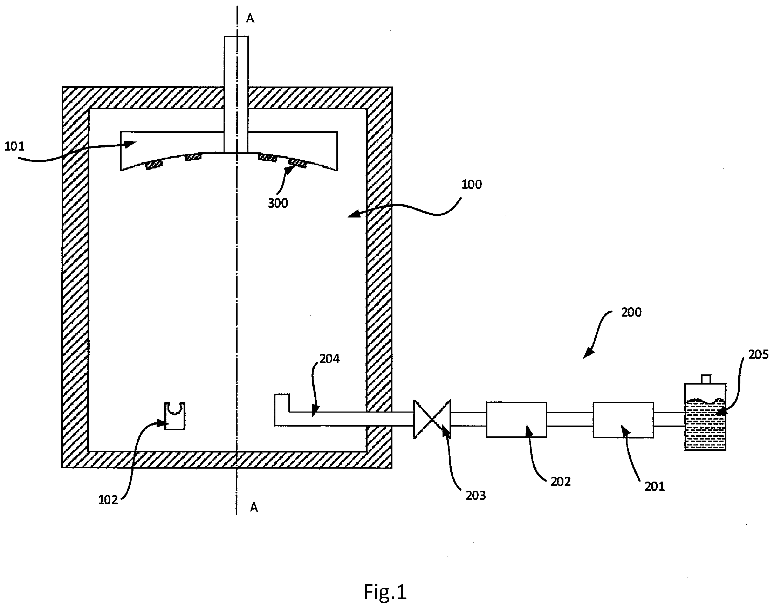

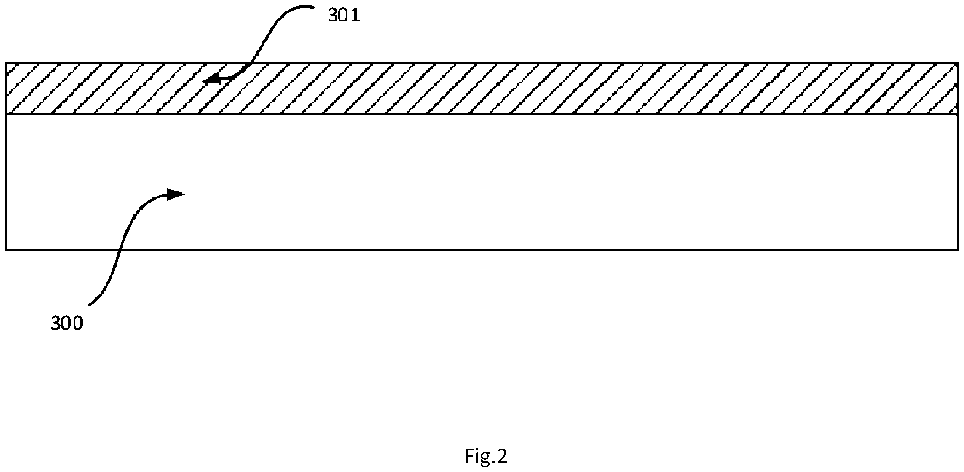

An outline of the structure of the film formation device provided according to the present embodiment will be described with reference to FIGS. 1 and 2. In the present embodiment, the film formation device is used to form a thin film 301 (the thin film may include an anti-dirt film or a hard film). A substrate 300 having the thin film 301 is particularly suitable for a touch panel, a display, an optical element, a satellite device, and other similar devices used in a smartphone and a tablet computer. The film formation device includes a vacuum chamber 100, an evacuation mechanism that is connected to the vacuum chamber 100 and evacuates the vacuum chamber 100, a substrate holding mechanism 101 that holds one or more substrates 300 in the vacuum chamber 100, a film formation mechanism 102 that is disposed in the vacuum chamber 100, and an introduction mechanism 200 that is connected to the vacuum chamber 100 and capable of introducing a hydroxyl group-containing gas into the vacuum chamber 100.

As illustrated in FIG. 1, the film formation device in the present embodiment includes the vacuum chamber 100. The vacuum chamber 100 is provided in a vacuum vessel. Among others, the vacuum vessel is a known film formation device and may be a commonly-used stainless steel vessel having an approximately cylindrical shape. The vacuum vessel is grounded to the earth.

The upper part of the vacuum vessel is provided with an evacuation port through which an evacuation mechanism is connected. The evacuation mechanism, which is connected to the vacuum chamber 100 via the evacuation port, can evacuate the interior of the vacuum chamber 100. The vacuum vessel forms the vacuum chamber 100 on the inner wall.

Specifically, the evacuation mechanism (not illustrated) may be a vacuum pump, which can be operated to evacuate the interior of the vacuum chamber 100 to a set pressure (e.g., about 1×10⁴ Pa to 3×10⁻² Pa).

The upper part of the vacuum chamber 100 is also provided with a substrate holder. The substrate holder (i.e., the substrate holding mechanism 101) is held rotatably about the vertical axis. The substrate holder is formed in a dome shape with a stainless steel member and connected to the output shaft of a motor (moving mechanism).

The bottom surface of the substrate holder is a substrate holding surface. During film formation, two or more substrates 300 are supported on the substrate holding surface. The center of the substrate holder of the present embodiment is provided with an opening, in which a quartz crystal monitor can be disposed. The resonance frequency of the quartz crystal monitor changes as the vapor deposition substance (vapor deposition substance of the film formation material) is deposited on the surface of the quartz crystal monitor. On the basis of the change in the resonance frequency, the film thickness detection unit detects the physical thickness of films that are formed on the surfaces of the substrates 300. The detection result of the film thickness is sent to a control device (not illustrated).

The upper part of the vacuum chamber 100 is disposed with an electric heating device (heating means) such that it surrounds the substrate holder from above. The temperature of the substrate holder is detected by a temperature sensor such as a thermocouple, and the detection result is sent to the control device.

The control device controls the open/close state of a shutter of a vapor deposition source, which will be described later, on the basis of the output from the film thickness detection unit, and appropriately controls the film thickness of the films formed on the substrates 300. The control device also controls the electric heating device on the basis of the output from the temperature sensor to appropriately manage the temperature of the substrates 300. The control device further manages the start and stop of the operation of the vapor deposition source.

In the present embodiment, the lower part of the vacuum chamber 100 is disposed with the film formation mechanism 102. The film formation mechanism 102 may be a vapor deposition source. An example of the film formation source is a vapor deposition source based on a resistance heating scheme (the resistance heating scheme may be a direct heating scheme, an indirect heating scheme, or other similar scheme). The vapor deposition source comprises a crucible and an openable and closable shutter. The upper part of the crucible has a recessed groove for placing the film formation material. The shutter is provided at a position at which the shutter can completely block the vapor deposition substance (film formation material) discharged from the crucible toward the substrates 300. The shutter is controlled to open and close by a command from the control device.

The vapor deposition source is not limited to being based on the resistance heating scheme and may also be a vapor deposition source based on an electron beam heating scheme. When the vapor deposition source is based on the electron beam heating scheme, the vapor deposition source may be provided with, in addition to the same crucible and shutter as the above, an electron gun that irradiates the film formation material with electron beams (e-) to vaporize the film formation material and an electron gun power source (both are not illustrated).

In the present embodiment, each substrate 300 after the film formation is coated (covered) with a thin film 301 that may have a silicon compound (organic silicon compound). The silicon compound, which will be described later, undergoes a hydrolysis condensation reaction on the surface to be coated of the substrate 300 (the substrate 300 may be transparent) thereby to form the thin film 301. The thin film 301 exhibits water repellency and oil repellency and can therefore act as those for various purposes. (For example, the thin film 301 may be an anti-dirt film. Among others, the anti-dirt film may include a lipophobic film, an oil repellent film, a hydrophobic film, or other similar film.)

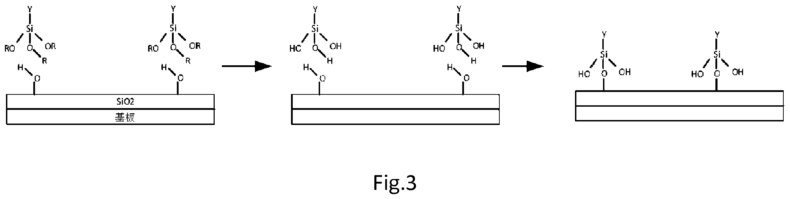

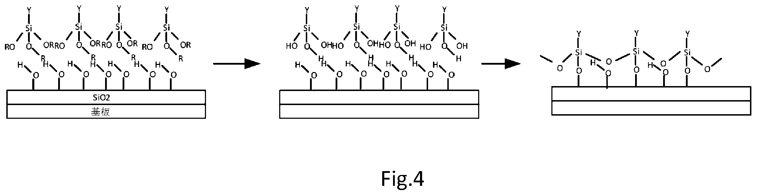

As can be found from the comparison between FIG. 3 and FIG. 4, for example, the hydroxyl group-containing gas is introduced to increase OH groups (hydroxyl groups) on the outermost layer of the substrate or of a silicon dioxide film (a film composed of a silicon compound) so that the OH groups react with OH portions of the vapor deposition material after the hydrolysis (this reaction may be, for example, a dehydration condensation reaction or a hydrolysis reaction) thereby to further form silanol (-SiOH). The silanol further undergoes intermolecular dehydration condensation to generate siloxane bonds represented by -Si-O-Si-, thus enhancing the interfacial adhesion (adhesiveness) of the thin film. This allows the thin film to have excellent wear resistance and contributes to the improvement of qualities of the thin film, such as chemical resistance (corrosion resistance) and UV resistance (ultraviolet resistance).

In the present embodiment, as illustrated in FIG. 2, the substrate 300 has a surface to be coated, and the thin film 301 is formed on this surface to be coated. Among others, the surface to be coated can be exposed in the hydroxyl group-containing environment which is formed in the vacuum chamber 100 by the introduction mechanism 200. This allows the thin film 301 to be formed which has high interfacial adhesion and can withstand the wear.

In general, the substrate 300 is not particularly limited in the present embodiment, provided that its material can achieve the anti-dirt performance when using the thin film 301. Specifically, the material of the substrate 300 may comprise at least one of glass, sapphire, aluminum, stainless steel, aluminum oxide, PET, polycarbonate (PC), and a triacetyl cellulose film (TAC). Preferably, the substrate 300 may be a transparent glass material, and examples thereof include soda lime glass, borosilicate glass, and quartz glass (silica glass). Quartz glass can be employed as a commonly-used one.

Examples of resins include acrylic-based resins such as polymethyl methacrylate, aromatic polycarbonate-based resins such as carbonate of bisphenol A, and aromatic polyester-based resins such as polyethylene terephthalate (PET). Among these, PET is preferred. From another aspect, it is particularly preferred to use glass as the substrate 300 because, as compared with resins, the wear resistance of the glass is significantly enhanced after the treatment with the hydroxyl group-containing gas.

In the present embodiment, when forming the thin film 301 on the surface to be coated of the substrate 300, the introduction mechanism 200 introduces (or feeds) the hydroxyl group-containing gas into the vacuum chamber 100 thereby to provide a larger amount of hydroxyl groups for film formation to form the film surface (thin film 301) which can withstand the wear. The introduction mechanism 200 is connected to the vacuum chamber 100 and feeds the hydroxyl group-containing gas into the vacuum chamber 100.

In the present embodiment, the hydroxyl group-containing gas is a gas that contains hydroxyl radicals in a vaporized state of the hydroxyl group-containing gas. Specifically, the hydroxyl group-containing gas may contain at least one of water and alcohol in a gaseous state. Among these, alcohol may be a generic name of materials having OH groups (such as methanol, ethanol, and isopropanol, for example). The hydroxyl group-containing gas may be alcohol in a gaseous state.

In an embodiment, the introduction mechanism 200 is capable of introducing two or more types of hydroxyl group-containing gases. For example, the gas introduced by the introduction mechanism 200 may be water vapor, ethanol, or a mixed gas of other gases of alcohols or may also be a mixed gas formed by mixing two or more types of alcohol gases. In practice, the hydroxyl group-containing gas is preferably water vapor in the present embodiment with consideration for the production cost of water vapor and the feature that the material can readily be obtained.

Considering that water has a low boiling point in a vacuum environment (relative vacuum), ideally, the introduction mechanism 200 may introduce liquid water into the vacuum chamber 100. After entering the vacuum chamber 100, the liquid water vaporizes to form water vapor and forms the hydroxyl group-containing gas.

To improve the qualities of film formation, the introduction mechanism 200 illustrated in FIG. 1 may include a vaporizer 201 capable of vaporizing water. The vaporizer 201 is connected to the vacuum chamber 100 via a pipe 204. The piping 204 is provided with a vacuum valve 203. In the present embodiment, the vaporizer 201 first vaporizes liquid water 205 to generate water vapor and then feeds the generated water vapor into the vacuum chamber 100 via the pipe 204, thereby avoiding a vaporization phenomenon that occurs in the vacuum chamber 100 to affect the temperature in the vacuum chamber 100.

The vacuum valve 203, which is provided in the pipe 204, controls conduction and closing of the pipe 204. The opening and closing of the vacuum valve 203 can control the introduction of the hydroxyl group-containing gas into the vacuum chamber 100. The transfer rate of the hydroxyl group-containing gas can be controlled by regulating the opening degree of the vacuum valve 203.

To well control the feed of the hydroxyl group-containing gas, the pipe 204 may be further provided with a gas flow meter 202. The gas flowmeter 202 can measure the transfer rate of the hydroxyl group-containing gas into the vacuum chamber 100. The vaporizer 201, the gas flow meter 202, and the vacuum valve 203 are connected in series by the pipe 204. The order of the series connection of the gas flow meter 202 and the vacuum valve 203 is not particularly limited in the present embodiment. Preferably, the gas flow meter 202 is disposed between the vacuum valve 203 and the vaporizer 201.

When the introduction mechanism 200 introduces the hydroxyl group-containing gas into the vacuum chamber 100 via the pipe 204, the direction of introducing the hydroxyl group-containing gas may be a direction of facing or a direction toward the surfaces to be coated of the substrates 300. In general, the surfaces to be coated of the substrates 300 are directed downward in the direction of gravity and it is therefore preferred to set the direction in which the hydroxyl group-containing gas enters the vacuum chamber 100 (i.e., the direction of introducing the hydroxyl group-containing gas into the vacuum chamber 100) in the upward direction. Accordingly, the substrates 300 and the surfaces to be coated thereof are positioned such that the direction of introducing the hydroxyl group-containing gas is upwind with respect to the substrates 300 and the surfaces to be coated thereof. As will be understood, the introduction mechanism 200 in the present embodiment is not limited to the above structure. In the present embodiment, it suffices that the introduction mechanism 200 can introduce the hydroxyl group-containing gas into the vacuum chamber 100.

As illustrated in FIG. 1, one end of the pipe 204 is arranged to pass through the lower part of the vacuum chamber 100. The substrate holding mechanism 101 holds the substrates 300 in the upper space inside the vacuum chamber 100. Such arrangement allows the hydroxyl group-containing gas discharged from the pipe 204 to be located below the surfaces to be coated of the substrates 300, so that the surfaces to be coated can be directly exposed to the hydroxyl group-containing gas. This is advantageous for the film formation. As will be understood, the pipe port (or the discharge port) of the pipe 204 may be provided so as to face the substrates 300 (it is not necessary to be vertical and may roughly face the substrates 300). This allows the discharged hydroxyl group-containing gas to steadily come into contact with the surfaces to be coated.

The introduction mechanism 200 in the present embodiment is not limited to the above-described vaporizer 201. The introduction mechanism 200 can directly introduce the generated water vapor into the vacuum chamber 100. For example, the introduction mechanism 200 may be connected to a storage tank that stores the hydroxyl group-containing gas (water vapor).

To acquire good film formation effects and acquire good film formation qualities, the introduction mechanism 200 can introduce the hydroxyl group-containing gas into the vacuum chamber 100 during or after the film formation executed by the film formation mechanism 102. In the present embodiment, whether or not the hydroxyl group-containing gas is introduced prior to the film formation is not particularly limited, and the hydroxyl group-containing gas may be introduced into the vacuum chamber 100 during or after the film formation.

When the thin films 301 are formed on the surfaces to be coated of the substrates 300, the introduction mechanism 200 introduces (or feeds), in this step, the hydroxyl group-containing gas into the vacuum chamber 100. The start or end of coating with the thin films 301 is not directly related to the start or end of introduction of the hydroxyl group-containing gas. In the present embodiment, it suffices that the introduction mechanism 200 can introduce the hydroxyl group-containing gas into the vacuum chamber 100 during the film formation. In the present embodiment, it also suffices that the introduction start time of the introduction mechanism 200 is earlier than the time when coating with the thin films 301 is completed.

In addition or alternatively, after the thin films 301 are formed on the surfaces to be coated of the substrates 300, the introduction mechanism 200 can introduce (or feed), in this step, the hydroxyl group-containing gas into the vacuum chamber 100. The start or end of coating with the thin films 301 is not directly related to the start or end of introduction of the hydroxyl group-containing gas. In the present embodiment, it suffices that the introduction mechanism 200 can introduce the hydroxyl group-containing gas into the vacuum chamber 100 after the film formation. In the present embodiment, it also suffices that the introduction end time of the introduction mechanism 200 is later than the time when coating with the thin films 301 is completed.

In the present embodiment, the film formation step of forming the thin films 301 corresponds to a step in which the surfaces to be coated are coated with the film formation material after it is vaporized. Specifically, the film formation step of forming the thin films 301 may be a step of vaporizing the vapor deposition source. That is, the introduction mechanism 200 introduces the hydroxyl group-containing gas into the vacuum chamber 100 during or after the vaporization of the vaporization source. As will be understood, considering that the step of vaporizing the vapor deposition source is related to the heating time, the film formation step of forming the thin films 301 in another example may be a step of heating the vapor deposition source.

In the present embodiment, the film formation device may be further provided with a moving mechanism. The moving mechanism moves the substrate holding mechanism 101 in the vacuum chamber 100 thereby to allow the substrates 300 to be intermittently supplied with the hydroxyl group-containing gas twice or more.

The substrate holding mechanism 101 can hold a plurality of substrates 300. The substrate holding mechanism 101 is partitioned into a plurality of placement areas, in which respective substrates 300 are placed. In general, the substrate holding mechanism 101 is disposed in the upper space of the vacuum chamber 100, and the introduction mechanism 200 introduces the hydroxyl group-containing gas into the lower apace of the vacuum chamber 100. As illustrated in FIG. 1, the substrate holding mechanism 101 is usually in an "umbrella-like shape" and the vapor deposition source is located below the substrate holding mechanism 101.

The moving mechanism can move the substrate holding mechanism 101 to spatially move the substrates 300. The movement of the substrate holding mechanism 101 may be parallel movement or rotational movement, and both the parallel movement and the rotational movement may be performed together. The substrate holding mechanism 101 can be spatially moved by the moving mechanism with a degree of freedom at least in one direction, and the hydroxyl group-containing gas can be intermittently supplied to the substrates 300 twice or more.

In the vacuum chamber 100, the introduction mechanism 200 does not move relative to the substrate holding mechanism 101 at the discharge position of the hydroxyl group-containing gas. In the step in which the substrates 300 are moved by the substrate holding mechanism 101, the hydroxyl group-containing gas is intermittently supplied to the substrates 300 twice or more. During this operation, the movement mechanism allows the substrate holding mechanism 101 to perform cyclic movement (e.g., reciprocating movement or circumferential movement).

As illustrated in FIG. 1, the moving mechanism can interlock and rotate the substrate holding mechanism 101 about the vertical axis A-A, that is, with the vertical axis A-A as the rotation axis. The introduction mechanism 200 is arranged so that the discharge position (e.g., the above pipe port of the pipe 204) for the hydroxyl group-containing gas in the vacuum chamber 100 is out of the axis A-A. That is, the introduction mechanism 200 is disposed in the vacuum chamber 100 so that the discharge position of the introduction mechanism 200 does not align with the rotation axis in the same line. In the step of rotating the substrate holding mechanism 101, the hydroxyl group-containing gas is intermittently supplied to the surfaces to be coated of the substrates 300. The moving mechanism may include a motor. The substrate holding mechanism 101 has a rotating shaft connected to the motor, and the rotation of the motor allows the substrate holding mechanism 101 to rotate.

In the present embodiment, the order of the introduction of the hydroxyl group-containing gas and the film formation of the thin films 301 is not limited. The introduction of the hydroxyl group-containing gas and the film formation may be concurrently performed, or the introduction of the hydroxyl group-containing gas may be performed prior to the film formation. The introduction of the hydroxyl group-containing gas may also be performed after the film formation. Thus, the timing of introduction of the hydroxyl group-containing gas is not limited in the present embodiment.

The steps of the film formation method provided by the present embodiment will be described with reference to FIGS. 1 and 2. In the present embodiment, the film formation method is used to form the thin films 301 (the thin films may include thin films such as anti-dirt films and hard films). The film formation method includes steps of a gas supply step of introducing the hydroxyl group-containing gas into the vacuum chamber 100 and a film formation step of forming the thin films 301 on the substrates 300.

Note that the film formation methods described below may be not only carried out using the above film formation device but also carried out using other film formation devices.

To acquire good film formation effects and acquire good film formation qualities, the gas supply step may be performed concurrently with the film formation step or may also be performed after the film formation step. In the present embodiment, whether or not the hydroxyl group-containing gas is introduced prior to the film formation is not particularly limited, and it suffices that the gas supply step is performed concurrently with the film formation step or performed after the film formation.

In an embodiment in which the film formation step and the gas supply step are concurrently performed, the hydroxyl group-containing gas is introduced (or fed) into the vacuum chamber 100 when the thin films 301 are formed on the surfaces to be coated of the substrates 300. The start or end of coating with the thin films 301 is not directly related to the start or end of introduction of the hydroxyl group-containing gas. In the present embodiment, it suffices that the hydroxyl group-containing gas is introduced into the vacuum chamber 100 during the film formation. In the present embodiment, it also suffices that the introduction start time is earlier than the time when coating with the thin films 301 is completed.

In an embodiment in which the gas supply step is performed after the film formation step, the introduction mechanism 200 introduces (or feeds) the hydroxyl group-containing gas into the vacuum chamber 100 after the thin films 301 are formed on the surfaces to be coated of the substrates 300. The start or end of coating with the thin films 301 is not directly related to the start or end of introduction of the hydroxyl group-containing gas, and it suffices the hydroxyl group-containing gas is introduced into the vacuum chamber 100 after the film formation. In the present embodiment, it also suffices that the introduction end time is later than the time when coating with the thin films 301 is completed.

In another embodiment, the film formation method may include a modified gas supply step and the film formation step. Specifically, the gas supply step is a step of moving the substrates 300 thereby to allow the substrates 300 to be intermittently supplied with the hydroxyl group-containing gas, and the film formation step is a step of forming the thin films 301 on the substrates 300..

In the present embodiment, the order of performing the gas supply step and performing the film formation step is not limited. The gas supply step and the film formation step may be concurrently performed, or the gas supply step may be performed prior to the film formation step. In addition or alternatively, the gas supply step may be performed after the film formation step, and the present embodiment is not limited to this.

In the gas supply step, the substrates 300 can move spatially. Among others, the movement of the substrates 300 may be parallel movement, rotation, or a combination of the two. The substrates 300 can move spatially with at least one degree of freedom, and it is considered that the substrates 300 can be intermittently supplied with the hydroxyl group-containing gas twice or more.

In the above embodiment, the film formation step for the thin films 301 may be considered as a step in which the film formation material is vaporized and the surfaces to be coated are then coated with the film formation material. Specifically, the film formation step for the thin films 301 may be a vaporization step for the vapor deposition source. That is, the hydroxyl group-containing gas is introduced into the vacuum chamber 100 during the vaporization step for the vapor deposition source or after the vaporization. As will be understood, considering that the vaporization step for the vapor deposition source is related to the heating time, the film formation step for the thin films 301 in another example may be a heating step for the vapor deposition source.

In the present embodiment, the gas supply step includes introducing the hydroxyl group-containing gas into the vacuum chamber 100 to a first set pressure P1. The first set pressure satisfies, for example, 1×10⁻³ Pa≤P1<1×10⁵ Pa. With the first set pressure, the wear resistance of the thin films 301 can be effectively improved and the high-quality film formation can be achieved.

The film formation device employing the above film formation method may be provided with a detection means that detects the pressure in the vacuum chamber 100. A pressure sensor is usually used for the detection means. The detection means detects the pressure in the vacuum chamber 100 in real time and thereby controls the amount of the hydroxyl group-containing gas to be introduced in real time in response to the detected pressure.

In the present embodiment, as the hydroxyl group-containing gas is consumed in the film formation step, the film formation step may include continuously introducing the hydroxyl group-containing gas so as to maintain a lot of hydroxyl groups in the vacuum chamber 100. In an alternative embodiment, the film formation step may include intermittently introducing the hydroxyl group-containing gas. Thus, the form of introducing the hydroxyl group-containing gas is not particularly limited in the present embodiment.

In the gas supply step, the pressure of the hydroxyl group-containing gas may be a constant pressure or may also be changed within a set range. When shifting from the film formation step to the gas supply step, the pressure may be changed or may also be maintained constant, and a predetermined time may be provided between the film formation step and the gas supply step.

In the present embodiment, the hydroxyl group-containing gas is a gas that contains hydroxyl radicals in the vaporized state of the hydroxyl group-containing gas. The hydroxyl group-containing gas may contain at least one of water and alcohol in a gaseous state. The alcohol may be a generic name of materials having OH groups (such as methanol, ethanol, and isopropanol, for example).

In an embodiment, the gas supply step may include introducing two or more types of hydroxyl group-containing gases. For example, the gas introduced in the gas supply step may be water vapor, ethanol in a gaseous state, or a mixed gas of other gases of alcohols or may also be a mixed gas formed by mixing two or more types of alcohol gases. The hydroxyl group-containing gas is preferably water vapor with consideration for the production cost of water vapor and the feature that the material can readily be obtained.

In a test, the inventors have found that the rate of introducing the gas affects the qualities and rate of the film formation. To acquire good film formation effects, the gas supply step includes introducing the hydroxyl group-containing gas for a time (t) and the time (t) satisfies t≤60 min. In addition or alternatively, the hydroxyl group-containing gas is introduced at a rate of 1 to 10,000 sccm.

The film formation method according to the present embodiment may further include a preliminary gas supply step of preliminarily introducing the hydroxyl group-containing gas into the vacuum chamber prior to the film formation step (the term "preliminarily" means that the gas supply is performed prior to the film formation step). By including the preliminary gas supply step, the content of the hydroxyl groups in the vacuum chamber 100 can be improved prior to the film formation (prior to heating the vapor deposition source or prior to vaporizing the film formation material). Thorough this operation, a larger amount of available hydroxyl groups can be formed on the surfaces to be coated of the substrates 300, and the hydroxyl groups can be sufficiently provided to form films at the start of film formation. Furthermore, the qualities of the thin films 301 can be more improved.

To improve the qualities of the film formation, the preliminary gas supply step may include introducing the hydroxyl group-containing gas into the vacuum chamber 100 to a second set pressure P2. The second set pressure P2 may satisfy 1×10⁻³ Pa≤P2<2×10⁴ Pa.

The film formation step may be performed immediately after the preliminary gas supply step. In this case, the process shifts from the preliminary gas supply step to the film formation step without interruption. In other words, the film formation step is executed immediately after execution of the preliminary gas supply step, and no other step exists between the two steps. This allows the hydroxyl group environment, which is formed in the vacuum chamber 100 by the preliminary gas supply step, to be appropriately used and the film formation qualities of the thin films 301 can thus be ensured.

The preliminary gas supply step may include introducing the hydroxyl group-containing gas for a time (t) and the time (t) may satisfy t≤60 min. The method may further include a silicon dioxide film formation step of performing film formation of silicon dioxide on the substrates 300 prior to the preliminary gas supply step. The silicon dioxide films can well utilize the hydroxyl groups, which are provided by the hydroxyl group-containing gas, to interact with the film formation material after vaporization. This can form the thin films 301 having good wear resistance on the outer surfaces of the silicon dioxide films.

In the above embodiment, as illustrated in FIG. 4, each thin film 301 is formed through the following steps. The hydrolyzable silyl of the above hydrolyzable silicon compound is converted to silanol groups due to hydrolysis and further subjected to intermolecular dehydration condensation to generate siloxane bonds represented by -Si-O-Si-. In the obtained thin film 301, almost all of the above fluorine-containing organic groups (exemplification) bonded to the silicon atoms of the siloxane bonds are present in the vicinity of the surface of the thin film 301 opposite to the substrate 300. The fluorine-containing organic groups can act to allow the thin film 301 to have water repellency and oil repellency. The above generated silanol groups undergo a dehydration condensation reaction with the hydroxyl groups (substrate 300-OH) on the surface to be coated so as to form chemical bonds, thereby forming adhesion points (substrate-O-Si).

Here, in the substrate 300 having the thin film 301 formed on the surface to be coated in the above steps, the density of hydroxyl groups on the surface to be coated is increased. This can enhance the interfacial adhesion between the surface to be coated and the thin film 301, and the substrate 300 can be obtained, having an anti-dirt film that can withstand repeated wiping operations or the like and has wear resistance. At the same time, the increase in the density of hydroxyl groups on the surface to be coated can enhance the interfacial adhesion (adhesiveness) of the thin film and can also contribute to total qualities of the thin film, such as chemical resistance (corrosion resistance) and UV resistance (ultraviolet resistance).

The detailed mechanism is not clear about enhancing the wear resistance of the substrate 300 having the obtained anti-dirt film to a high level, but it can be considered that, in the present embodiment, the above process increases the density of hydroxyl groups on the surface to be coated and the number of adhesion points between the substrate 300 and the thin film 301 thereby to improve the wear resistance. It may also be considered that the cause of increase in the density of hydroxyl groups is that the presence of water molecules induces the generation of new hydroxy groups.

The above effects were verified in the following test as well.

The film formation process according to the above embodiment was performed on a substrate 300 to obtain the substrate 300 with a thin film 301 (Example). A simplified film formation process including only the film formation step was performed on another similar substrate to obtain a substrate 300 with a thin film 301 (Comparative Example). Then, wear resistance test was performed on the substrate 300 with the thin film 301 of Example and the substrate 300 with the thin film 301 of Comparative Example.

In the wear resistance test, steel wool of the same material and the same shape was used to apply the friction to the substrate 300 of Example and the substrate 300 of Comparative Example with the same biasing force and the same number of times of friction on the SW tester, and each of the substrates 300 was evaluated. The conditions of the test are listed in the following table.

### [Table 1]

**Table 1**

| Measurement Conditions of SW Test | |
|---|---|
| Wear material | Steel wool (BON STAR #0000) |
| Size (mm) | 10×10 |
| Load (g) | 1,000 |
| Stroke length (mm) | 50 |
| Stroke rate (cycle/min) | 60 |

After completion of the test, the water contact angle on each of the thin films 301 of the above Example and Comparative Example was measured.

Results are listed in the following table.

### [Table 2]

**Table 2**

| Measurement Results of SW Test | | | |
|---|---|---|---|
| | Water contact angle on experimental area | | |
| Number of times of friction | 0 | 2,000 | 10,000 |
| With hydroxyl group-containing gas supply step (Example) | 115.1 | 114.7 | 109.9 |
| Without hydroxyl group-containing gas supply step (Comparative Example) | 115.1 | 109.7 | 105.2 |

As found from the above test results, the film formation device and film formation method provided by the above embodiment can offer a wear-resistant substrate that has such properties as water repellency and oil repellency thereby to obtain excellent anti-dirt properties or oil repellency and that can suppress the deterioration of the anti-dirt properties in the repeated wiping operations or the like.

Digital values include all lower and upper values increasing with one unit between the lower and upper limits and it suffices that at least two units of spacing exist between any lower value and any higher value. For example, if it is stated that the number of components of one type or the value of a process variable (such as a temperature, pressure, or time) is 1 to 90, preferably 20 to 80, and more preferably 30 to 70, it is intended to explain, for example, that values such as 15 to 85, 22 to 68, 43 to 51, or 30 to 32 are also explicitly listed in the description. For values less than one, one unit is properly considered to be 0.0001, 0.001, 0.01, or 0.1. These are merely examples for clear expression and it can be considered that all possible combinations of numerical values listed between the lowest and highest values are also explicitly stated in the description in a similar manner.

Unless otherwise stated, any of ranges includes the endpoints and all numerals between the endpoints. The term "about" or "approximately" used with a range is applicable to the two endpoints of the range. Thus, "about 20 to 30" is intended to cover "about 20 to about 30" and includes at least the specified endpoints.

All the disclosed text and references (including patent applications and publications) are described herein by reference for various purposes. The term "consisting essentially of' for describing a combination is considered to include the determined elements, components, parts, or steps and other elements, components, parts, or steps that do not substantially affect the basic novelty requirements of the combination. As for describing a combination of elements, components, parts, or steps herein using the term such as "comprise" or "comprising," an embodiment consisting essentially of these elements, components, parts, or steps is also conceivable. It is intended that the term "can (may, possible)" can be used thereby to explain that any attribute described with "can (may, possible)" is selectable.

Two or more elements, components, parts, or steps can be provided by a single integrated element, component, part, or step. Alternatively, a single integrated element, component, part, or step can be divided into two or more separate elements, components, parts, or steps. The term "a (an)" or "one" disclosed to describe an element, component, part, or step does not exclude other elements, components, parts, or steps.

It can be considered that the above description is not for limitation and the drawings are for descriptive purposes.

### [Description of Reference Numerals]

- 100: Vacuum chamber
- 101: Substrate holding mechanism
- 200: Introduction mechanism
- 201: Vaporizer
- 202: Gas flow meter
- 203: Vacuum valve
- 204: Pipe
- 300: Substrate
- 301: Thin film

## Claims

1. A film formation device for forming a thin film, comprising:
a vacuum chamber;
an evacuation mechanism that is connected to the vacuum chamber and evacuates the vacuum chamber;
a substrate holding mechanism that holds a substrate in the vacuum chamber;
a film formation mechanism that is disposed in the vacuum chamber; and
an introduction mechanism that is connected to the vacuum chamber and capable of introducing a hydroxyl group-containing gas into the vacuum chamber during film formation by the film formation mechanism.

2. A film formation device for forming a thin film, comprising:
a vacuum chamber;
an evacuation mechanism that is connected to the vacuum chamber and evacuates the vacuum chamber;
a substrate holding mechanism that holds a substrate in the vacuum chamber;
a film formation mechanism that is disposed in the vacuum chamber; and
an introduction mechanism that is connected to the vacuum chamber and capable of introducing a hydroxyl group-containing gas into the vacuum chamber after film formation by the film formation mechanism.

3. A film formation device for forming a thin film, comprising:
a vacuum chamber;
an evacuation mechanism that is connected to the vacuum chamber and evacuates the vacuum chamber;
a substrate holding mechanism that holds a substrate in the vacuum chamber;
a film formation mechanism that is disposed in the vacuum chamber;
an introduction mechanism that is connected to the vacuum chamber and capable of introducing a hydroxyl group-containing gas to the substrate; and
a moving mechanism that moves the substrate holding mechanism in the vacuum chamber thereby to allow the substrate to be intermittently supplied with the hydroxyl group-containing gas twice or more.

4. The film formation device according to any one of claims 1 to 3, wherein the hydroxyl group-containing gas contains at least one of water and alcohol in a gaseous state.

5. The film formation device according to claim 4, wherein the introduction mechanism is capable of introducing two or more types of hydroxyl group-containing gases.

6. The film formation device according to any one of claims 1 to 3, wherein the introduction mechanism includes a vaporizer capable of vaporizing water, and the vacuum chamber is connected to the vaporizer via a pipe provided with a vacuum valve.

7. The film formation device according to claim 6, wherein the pipe is provided with a gas flow meter.

8. The film formation device according to claim 7, wherein the gas flow meter is disposed between the vacuum valve and the vaporizer.

9. The film formation device according to claim 8, wherein one end of the pipe is arranged to pass through a lower part of the vacuum chamber.

10. The film formation device according to any one of claims 1 to 3, wherein the thin film includes an anti-dirt film or a hard film.

11. A film formation method comprising:
a gas supply step of introducing a hydroxyl group-containing gas into a vacuum chamber; and
a film formation step of forming a thin film on a substrate,
wherein the gas supply step and the film formation step are concurrently performed.

12. A film formation method comprising:
a gas supply step of introducing a hydroxyl group-containing gas into a vacuum chamber; and
a film formation step of forming a thin film on a substrate,
wherein the gas supply step is performed after the film formation step.

13. A film formation method comprising:
a gas supply step of moving a substrate thereby to allow the substrate to be intermittently supplied with a hydroxyl group-containing gas; and
a film formation step of forming a thin film on the substrate.

14. The method according to any one of claims 11 to 13, comprising
a preliminary gas supply step of preliminarily introducing the hydroxyl group-containing gas into the vacuum chamber prior to the film formation step.

15. The method according to any one of claims 11 to 13, wherein the hydroxyl group-containing gas contains at least one of water vapor and alcohol vapor.

16. The method according to claim 15, wherein the gas supply step includes introducing two or more types of hydroxyl group-containing gases.

17. The method according to any one of claims 11 to 13, wherein the gas supply step includes introducing the hydroxyl group-containing gas into the vacuum chamber to a first set pressure P1 and the first set pressure P1 satisfies 1×10⁻³ Pa≤P1<1×10⁵ Pa.

18. The method according to claim 14, wherein the preliminary gas supply step includes introducing the hydroxyl group-containing gas into the vacuum chamber to a second set pressure P2 and the second set pressure P2 satisfies 1×10⁻³ Pa≤P2<2×10⁴ Pa.

19. The method according to claim 18, wherein the film formation step is performed immediately after the preliminary gas supply step.

20. The method according to any one of claims 11 to 13, wherein the gas supply step includes introducing the hydroxyl group-containing gas for a time (t) and the time (t) satisfies t≤60 min.

21. The method according to claim 14, wherein the preliminary gas supply step includes introducing the hydroxyl group-containing gas for a time (t) and the time (t) satisfies t≤60 min.

22. The method according to any one of claims 11 to 13, wherein the hydroxyl group-containing gas is introduced at a rate of 1 to 10,000 sccm.

23. The method according to claim 14, comprising a silicon dioxide film formation step of performing film formation of silicon dioxide on the substrate prior to the preliminary gas supply step.

24. The method according to any one of claims 11 to 13, wherein the hydroxyl group-containing gas is water vapor.

25. The method according to any one of claims 11 to 13, wherein a material of the substrate comprises at least one of glass, sapphire, aluminum, stainless steel, aluminum oxide, PET, polycarbonate (PC), and a triacetyl cellulose film (TAC).

26. The method according to any one of claims 11 to 13, wherein the thin film includes an anti-dirt film or a hard film.
